Europäisches Patentamt

(19) European Patent Office

Office européen des brevets

(11) EP 0 826 793 A1

(12) EUROPEAN PATENT APPLICATION

(43) Date of publication:
04.03.1998 Bulletin 1998/10

(51) Int. Cl.$^6$: C23F 1/44

(21) Application number: 97114756.6

(22) Date of filing: 26.08.1997

(84) Designated Contracting States:
AT BE CH DE DK ES FI FR GB GR IE IT LI LU MC
NL PT SE

(30) Priority: 30.08.1996 JP 230463/96

(71) Applicant: MEC CO., Ltd.
Amagasaki-shi, Hyogo-ken (JP)

(72) Inventors:
• Akiyama, Daisaku
  Amagasaki-shi, Hyogo-ken (JP)
• Yaguma, Noriko
  Amagasaki-shi, Hyogo-ken (JP)

(74) Representative:
Wächtershäuser, Günter, Prof. Dr.
Patentanwalt,
Tal 29
80331 München (DE)

(54) Composition for stripping tin or tin alloys

(57) A composition for stripping tin or tin alloys from a copper substrate. The composition is an aqueous solution comprising 150-300 g/l nitric acid, 5-25 g/l iron ions, 2-20 g/l chloride ions, and a specific amount of at least one compound selected from iodine compounds, cobalt compounds, nickel compounds, and zinc compounds. The solution can effectively control a decrease in the stripping rate with the running of stripping operations.

Description

## BACKGROUND OF THE INVENTION

### Field of the Invention

The present invention relates to a composition for stripping tin or tin alloys from a copper substrate and, more particularly, to a composition for stripping tin or tin alloys (for example tin-lead alloy which is called solder) formed as an etching resist of copper substrate in the course of manufacturing printed circuit boards.

### Description of the Background Art

A solder stripping method is one of the techniques used in manufacturing printed circuit boards. This method comprises plating solder with a prescribed pattern on a copper substrate of a copper-clad laminated board, etching the copper substrate using this solder pattern as an etching resist to form a copper pattern, and stripping the solder. A stripping composition containing nitric acid and iron ions as major components, a stripping composition containing hydrogen peroxide and a fluorine compound as major components, a stripping composition containing an inorganic acid and a nitro group-substituted aromatic compound as major components, and the like are known as stripping compositions used in this method. Of these, the stripping composition containing nitric acid and iron ions as major components are more widely accepted because toxic fluorine compounds are not used, there is minimal redeposition of tin on the copper substrate, and the like.

A problem with this solder stripping method is a decrease in the solder stripping rate when the amount of solder dissolved increases as the solder stripping operation runs. This applies also to the method using the stripping composition containing nitric acid and iron ions as major components. If this decrease in the solder stripping rate can be controlled, the life of the stripping composition can be extended, bringing about a great advantage in workability and reduced production costs.

The present inventors have conducted extensive studies to solve this problem and found that the decrease in the solder stripping rate can be effectively controlled by adding at least one compound selected from the group consisting of iodine compounds, cobalt compounds, nickel compounds, and zinc compounds to a stripping composition which comprises nitric acid, iron ions, and chloride ions. This finding has led to the completion of the present invention.

## SUMMARY OF THE INVENTION

Accordingly, an object of the present invention is to provide a composition for stripping tin or tin alloys from a copper substrate comprising an aqueous solution which comprises 150-300 g/l nitric acid, 5-25 g/l iron ions, 2-20 g/l chloride ions, and an iodine compound at a concentration in the range of 10-500 ppm (weight) as iodine.

Another object of the present invention is to provide a composition for stripping tin or tin alloys from a copper substrate comprising an aqueous solution which comprises 150-300 g/l nitric acid, 5-25 g/l iron ions, 2-20 g/l chloride ions, and at least one compound selected from cobalt compounds, nickel compounds, and zinc compounds at a concentration in the range of 0.1-50 g/l as the concentration of the total of cobalt, nickel, and zinc.

Still another object of the present invention is to provide a composition for stripping tin or tin alloys from a copper substrate comprising an aqueous solution which comprises 150-300 g/l nitric acid, 5-25 g/l iron ions, 2-20 g/l chloride ions, an iodine compound at a concentration in the range of 10-500 ppm (weight) as iodine, and at least one compound selected from cobalt compounds, nickel compounds, and zinc compounds at a concentration in the range of 0.1-50 g/l as the concentration of the total of cobalt, nickel, and zinc.

Other objects, features and advantages of the invention will hereinafter become more readily apparent from the following description.

## DETAILED DESCRIPTION OF THE INVENTION AND PREFERRED EMBODIMENTS

The concentration of nitric acid in the stripping composition of the present invention is 150-300 g/l and preferably 230-270 g/l. If this concentration is less than 150 g/l, the stripping composition exhibits insufficient solubility for tin or tin alloys; if more than 300 g/l, the solubilizing capability relating to tin or tin alloys is so large that no smooth copper surface may be obtained.

The concentration of iron ions is 5-25 g/l and preferably 10-17 g/l. If the concentration of iron ions is less than 5 g/l, the stripping composition exhibits insufficient solubility for tin or tin alloys. If the concentration is more than 25 g/l, the solubilizing capability of the composition to tin or tin alloys is so large that no smooth copper surface may be obtained or discoloration of the copper surface may occur. The iron ions are usually added as a ferric salt, such as ferric chloride or ferric nitrate, or as iron metal.

The concentration of chloride ions is 2-20 g/l and preferably 5-10 g/l. If less than 2 g/l, the stripping rate of the tin-copper intermetallic layer which is present in the interface of tin and copper is too small; if more than 20 g/l, erosion of copper is large. The chloride ions are usually added as a compound which can liberate chloride ions in the stripping composition, for instance, a chloride, such as hydrochloric acid, ferric chloride, sodium chloride, potassium chloride, ammonium chloride, cobalt chloride, nickel chloride, or zinc chloride; chloric acid; or a chlorate.

The concentration of iodine, when an iodine compound is added to the stripping composition of the present invention, is in the range of 10-500 ppm (weight) and preferably 70-150 ppm (weight). The iodine not only controls a decrease in the solder stripping rate but also has a remarkable effect of controlling erosion of a copper substrate. If less than 10 ppm (weight), the effect of controlling the decrease in the solder stripping rate and the effect of suppressing the erosion of copper substrate is small; if larger than 500 ppm (weight), an epoxy resin used for the substrate of a printed circuit board is sometimes colored. There are no specific limitations to the iodine compound used here inasmuch as such a compound liberates iodine or iodide ion in the stripping composition. Specific examples include an iodide, such as sodium iodide, ammonium iodide, or potassium iodide; iodic acid; an iodate; periodic acid; and a periodate. Among these, iodic acid and an iodate are preferred in view of excellent storage stability of the stripping solution.

When at least one of the compounds selected from cobalt compounds, nickel compounds, and zinc compounds is added to the stripping composition of the present invention, the concentration of the total of cobalt, nickel, and zinc is 0.1-50 g/l, and preferably 1-10 g/l. If this concentration is less than 0.1 g/l, the effect of controlling the decrease in the solder stripping rate is small. On the other hand, no additional effects may be obtained proportionately to the amount of these metals exceeding 50 g/l. Thus, any amount larger than 50 g/l only brings about an increase in the cost.

A cobalt salt such as cobalt nitrate, cobalt chloride, cobalt iodide, or cobalt ethylenediaminetetraacetate, or a water soluble cobalt coordination compound can be used as the cobalt compound without any specific limitation. As the nickel compound, a nickel salt such as nickel nitrate, nickel chloride, nickel iodide, or nickel ethylenediaminetetraacetate, or a water soluble nickel coordination compound can be used without any specific limitation. As the zinc compound, a zinc salt such as zinc nitrate, zinc chloride, zinc iodide, or zinc ethylenediaminetetraacetate, or a water soluble zinc coordination compound can be used without any specific limitation.

Of these compounds, cobalt iodide, nickel iodide, and zinc iodide are used in such amounts that the iodine concentration does not exceed 500 ppm (weight). Another cobalt compound, nickel compound, or zinc compound, or a mixture of these is therefore used in combination for the balance.

The combined use of an iodine compound and at least one compound selected from the group consisting of cobalt compounds, nickel compounds, and zinc compounds is particularly preferred in the stripping composition of the present invention.

An inhibitor, sludge preventive agent, and other components may be optionally added to the stripping composition of the present invention.

The inhibitor is a component added to prevent rust and discoloration of the copper surface after stripping of solder. Given as preferred examples of inhibitors are benzotriaole, benzoimidazole, imidazole, derivatives of them, propylene glycol, ethylenediamine, diethylene glycol, bisphenol A, ethylene oxide adduct or ethylene oxide-propylene oxide adduct of these (preferably, ethylene oxide-propylene oxide adduct with an propylene oxide terminal), ethylene oxide-propylene oxide copolymers, and the like. The content of the inhibitors is preferably in the range of 0.5-20 g/l.

The sludge preventive agent is added to prevent formation of white precipitates when the stripping operation of tin or tin alloy is carried out for a long period of time. Examples of preferred sludge preventive agents include citric acid, sodium citrate, potassium citrate, ammonium citrate, sodium glutamate, L-arginine hydrochloride, and the like. The content of the sludge preventive agent is preferably in the range of 5-80 g/l.

There are no specific limitations to the method for preparing the stripping composition of the present invention. The components to be incorporated are simply dissolved in water, preferably in ion exchanged water. Also, there are no specific limitations to the method for using the stripping composition of the present invention. Usually, the stripping composition is sprayed over the material to be treated or, alternatively, such materials may be immersed in the stripping composition.

Other features of the invention will become apparent in the course of the following description of the exemplary embodiments which are given for illustration of the invention and are not intended to be limiting thereof.

## EXAMPLES

Examples 1-11 and Comparative Examples 1-2

Substrates (length: 4 cm, width: 4 cm) for printed circuit board comprising a copper foil laminated to an insulator, with a solder having an Sn:Pb ratio of 6:4 being electroplated on the copper foil, were provided. Stripping compositions (A Solutions) with the composition shown in Tables I-1, I-2, I-3, 2, and 3 were sprayed over the substrates to strip the solder under the conditions of solution temperature 30°C and spray pressure 1 kgf/cm$^2$. The stripping rate was calculated according to the following formula.

$$\text{Solder stripping rate} = \frac{(\text{Weight of substrate before stripping}) - (\text{Weight of substrate after stripping})}{(\text{Specific gravity of solder}) \times (\text{Surface area of solder}) \times (\text{Treating time})}$$

The results are shown in Tables I-1, I-2, I-3, 2, and 3.

Next, to examine the decrease in the solder stripping rate while the stripping operation runs, B Solutions were prepared by dissolving 150 g/l of solder respectively in A Solutions. The solder stripping rates were examined in the same manner as above, using the B Solutions. The results are shown in Tables I-1, I-2, I-3, 2, and 3.

Moreover, to evaluate erosion of copper substrates, the A Solutions were sprayed onto the copper foil laminated to the insulator (no solder plated) under the same conditions as mentioned above, and the copper dissolving rate was calculated. The results are shown in Tables I-1, I-2, I-3, 2, and 3.

TABLE I-1

| | Composition of stripping composition (g/l) | | | A Solution | | (B Solution) | Decrease in the solder stripping rate (%) |
|---|---|---|---|---|---|---|---|
| | | | | Solder stripping rate ($\mu$m/min) | Copper dissolving rate ($\mu$m/min) | Solder stripping rate ($\mu$m/min) | |
| Comparative Example 1 | 67.5% Nitric acid<br>Ferric nitrate · 9H$_2$O<br>Sodium chloride<br>Benzotriazole<br>Ion exchanged water | 400<br>125<br>15<br>10<br>Balance | (Nitric acid 270)<br>(Iron    21.5)<br>(Chlorine  9.1) | 37.23 | 5.21 | 4.85 | 87.0 |
| Example 1 | 67.5% Nitric acid<br>Ferric nitrate · 9H$_2$O<br>Sodium chloride<br>Benzotriazole<br>Sodium iodide<br>Ion exchanged water | 400<br>125<br>15<br>10<br>150 ppm<br>Balance | (Nitric acid 270)<br>(Iron    21.5)<br>(Chlorine  9.1)<br><br>(Iodine 127.0 ppm) | 16.84 | 0.95 | 4.73 | 71.9 |
| Example 2 | 67.5% Nitric acid<br>Ferric nitrate · 9H$_2$O<br>Sodium chloride<br>Benzotriazole<br>Zinc nitrate · 6H$_2$O<br>Ion exchanged water | 400<br>125<br>15<br>10<br>32<br>Balance | (Nitric acid 270)<br>(Iron    21.5)<br>(Chlorine  9.1)<br><br>(Zinc  7.1) | 33.90 | 5.03 | 10.51 | 67.0 |

TABLE I-2

| | Composition of stripping composition (g/l) | A Solution | | (B Solution) | Decrease in the solder stripping rate (%) |
|---|---|---|---|---|---|
| | | Solder stripping rate (μm/min) | Copper dissolving rate (μm/min) | Solder stripping rate (μm/min) | |
| Example 3 | 67.5% Nitric acid 400 (Nitric acid 270)<br>Ferric nitrate · 9H$_2$O 125 (Iron 21.5)<br>Sodium chloride 15 (Chlorine 9.1)<br>Benzotriazole 10<br>Nickel nitrate (anhydride) 22 (Nickel 7.1)<br>Ion exchanged water Balance | 35.43 | 5.32 | 9.84 | 72.2 |
| Example 4 | 67.5% Nitric acid 400 (Nitric acid 270)<br>Ferric nitrate · 9H$_2$O 125 (Iron 21.5)<br>Sodium chloride 15 (Chlorine 9.1)<br>Benzotriazole 10<br>Cobalt(II) nitrate · 6H$_2$O 35 (Cobalt 7.1)<br>Ion exchanged water Balance | 34.21 | 4.99 | 10.16 | 70.3 |
| Example 5 | 67.5% Nitric acid 400 (Nitric acid 270)<br>Ferric nitrate · 9H$_2$O 125 (Iron 21.5)<br>Sodium chloride 15 (Chlorine 9.1)<br>Benzotriazole 10<br>Sodium iodide 150 ppm (Iodine 127.0 ppm)<br>Zinc nitrate · 6H$_2$O 32 (Zinc 7.0)<br>Ion exchanged water Balance | 23.69 | 1.47 | 12.38 | 47.7 |

TABLE I-3

| | Composition of stripping composition (g/l) | | | A Solution | | (B Solution) | Decrease in |
|---|---|---|---|---|---|---|---|
| | | | | Solder stripping rate (μm/min) | Copper dissolving rate (μm/min) | Solder stripping rate (μm/min) | the solder stripping rate (%) |
| Example 6 | 67.5% Nitric acid 400 (Nitric acid 270)<br>Ferric nitrate · 9H$_2$O 125 (Iron 21.5)<br>Sodium chloride 15 (Chlorine 9.1)<br>Benzotriazole 10<br>Sodium iodide 150 ppm (Iodine 127.0 ppm)<br>Nickel nitrate (anhydride) 22 (Nickel 7.1)<br>Ion exchanged water Balance | | | 20.33 | 1.17 | 11.86 | 41.7 |
| Example 7 | 67.5% Nitric acid 400 (Nitric acid 270)<br>Ferric nitrate · 9H$_2$O 125 (Iron 21.5)<br>Sodium chloride 15 (Chlorine 9.1)<br>Benzotriazole 10<br>Sodium iodide 150 ppm (Iodine 127.0 ppm)<br>Cobalt(II) nitrate · 6H$_2$O 35 (Cobalt 7.1)<br>Ion exchanged water Balance | | | 21.86 | 1.23 | 12.36 | 43.5 |

TABLE 2

| | Composition of stripping composition (g/l) | | A Solution | | (B Solution) Solder stripping rate (μm/min) | Decrease in the solder stripping rate (%) |
|---|---|---|---|---|---|---|
| | | | Solder stripping rate (μm/min) | Copper dissolving rate (μm/min) | | |
| Comparative Example 2 | 67.5% Nitric acid 380<br>Ferric nitrate · 9H$_2$O 100<br>Sodium chloride 20<br>Ion exchanged water Balance | (Nitric acid 256.5)<br>(Iron 17.3)<br>(Chlorine 12.1) | 32.61 | 6.25 | 4.57 | 86.0 |
| Example 8 | 67.5% Nitric acid 380<br>Ferric nitrate · 9H$_2$O 100<br>Sodium chloride 20<br>Ammonium iodide 80 ppm<br>Ion exchanged water Balance | (Nitric acid 256.5)<br>(Iron 17.3)<br>(Chlorine 12.1)<br>(Iodine 70.0 ppm) | 20.21 | 2.71 | 6.11 | 69.8 |
| Example 9 | 67.5% Nitric acid 380<br>Ferric nitrate · 9H$_2$O 100<br>Sodium chloride 20<br>Ammonium iodide 170 ppm<br>Ion exchanged water Balance | (Nitric acid 256.5)<br>(Iron 17.3)<br>(Chlorine 12.1)<br>(Iodine 148.8 ppm) | 19.3 | 1.83 | 5.84 | 69.2 |

TABLE 3

| Composition of stripping composition (g/l) | | A Solution | | (B Solution) Solder stripping rate (μm/min) | Decrease in the solder stripping rate (%) |
|---|---|---|---|---|---|
| | | Solder stripping rate (μm/min) | Copper dissolving rate (μm/min) | | |
| Comparative Example 2 | 67.5% Nitric acid 380 (Nitric acid 256.5)<br>Ferric nitrate · 9H₂O 100 (Iron 17.3)<br>Sodium chloride 20 (Chlorine 12.1)<br>Ion exchanged water Balance | 32.61 | 6.25 | 4.57 | 86.0 |
| Example 10 | 67.5% Nitric acid 380 (Nitric acid 256.5)<br>Ferric nitrate · 9H₂O 100 (Iron 17.3)<br>Sodium chloride 20 (Chlorine 12.1)<br>Ammonium iodide 120 ppm (Iodine 105.1 ppm)<br>Nickel nitrate (anhydride) 3 (Nickel 1.0)<br>Ion exchanged water Balance | 19.63 | 1.33 | 7.69 | 60.8 |
| Example 11 | 67.5% Nitric acid 380 (Nitric acid 256.5)<br>Ferric nitrate · 9H₂O 100 (Iron 17.3)<br>Sodium chloride 20 (Chlorine 12.1)<br>Ammonium iodide 170 ppm (Iodine 148.8 ppm)<br>Nickel nitrate (anhydride) 30 (Nickel 9.7)<br>Ion exchanged water Balance | 22.02 | 1.09 | 12.13 | 44.9 |

It can be seen from the Tables I-1, I-2, I-3, 2, and 3, the stripping compositions of the present invention suppress a decrease in the solder stripping rate about over 15% as compared with the stripping compositions in Comparative Examples 1 and 2. Particularly, in Examples 5-7 and 10-11 in which a zinc compound, nickel compound, or cobalt compound is used in combination with an iodine compound, the decrease in the solder stripping rate was suppressed about more than 25% as compared with the stripping compositions in Comparative Examples 1 and 2. In addition, erosion of copper was effectively suppressed in these examples.

Because the stripping composition of the present invention effectively suppresses a decrease in the solder stripping rate in comparison with conventional stripping composition, the stripping composition of the present invention can be used for an extended period of time. This stripping composition thus brings about a great advantage in workability and reduced production costs.

Obviously, numerous modifications and variations of the present invention are possible in light of the above teachings. It is therefore to be understood that, within the scope of the appended claims, the invention may be practiced otherwise than as specifically described herein.

### Claims

1.  A composition for stripping tin or tin alloys from a copper substrate comprising an aqueous solution which comprises 150-300 g/l nitric acid, 5-25 g/l iron ions, 2-20 g/l chloride ions, and an iodine compound at a concentration in the range of 10-500 ppm (weight) as iodine.

2.  The composition according to claim 1, containing an iodine compound at a concentration in the range of 70-150 ppm (weight) as iodine.

3.  A composition for stripping tin or tin alloys from a copper substrate comprising an aqueous solution which comprises 150-300 g/l nitric acid, 5-25 g/l iron ions, 2-20 g/l chloride ions, and at least one compound selected from cobalt compounds, nickel compounds, and zinc compounds at a concentration in the range of 0.1-50 g/l as the concentration of the total of cobalt, nickel, and zinc.

4.  A composition for stripping tin or tin alloys from a copper substrate comprising an aqueous solution which comprises 150-300 g/l nitric acid, 5-25 g/l iron ions, 2-20 g/l chloride ions, an iodine compound at a concentration in the range of 10-500 ppm (weight) as iodine, and at least one compound selected from cobalt compounds, nickel compounds, and zinc compounds at a concentration in the range of 0.1-50 g/l as the concentration of the total of cobalt, nickel, and zinc.

5.  The composition according to claim 1, 2, 4 or 5, wherein the iodine compound is iodic acid or an iodate.

6.  A method for stripping tin or a tin alloy from a copper substrate comprising applying a composition defined in any one of the claims 1-5 to a material with tin or a tin alloy plated on a copper substrate.

7.  The method according to claim 6, wherein application of the composition is carried out by spraying the composition over said material or immersing said material into the composition.

**European Patent Office**

## EUROPEAN SEARCH REPORT

Application Number

EP 97 11 4756

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 5 244 539 A (MCGRATH PETER T ET AL) * column 4, line 35-39; claims 15,23 * | 1,6 | C23F1/44 |
| X | DD 148 067 A (SCHNEIDER M.) * claims 1,2; example 1 * | 3 | |
| X | US 4 244 833 A (TOMASZEWSKI LILLIE C) * claims 1,5,7,10,13,14 * | 3 | |
| A | EP 0 559 379 A (MACDERMID INC) | | |
| A | EP 0 315 891 A (RUWEL WERKE GMBH) | | |
| A | US 5 505 872 A (KRULIK GERALD A ET AL) | | |
| A | GB 1 196 495 A (MACDERMID INCORPORATED) | | |
| A | US 3 057 764 A (LA BODA M. A.) | | |

TECHNICAL FIELDS
SEARCHED (Int.Cl.6)

C23F

The present search report has been drawn up for all claims

| Place of search | Date of completion of the search | Examiner |
|---|---|---|
| THE HAGUE | 27 November 1997 | Torfs, F |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document